# EUROPEAN PATENT APPLICATION

(11) **EP 3 527 102 A1**
(43) Date of publication of application: **21.08.2019**
(21) Application number: 18745481.4
(22) Date of filing: 19.06.2018
(51) Int. Cl.: A45B 9/02, A45B 23/00, H02J 7/35

(54) **PARASOL**

(30) Priority: 19.12.2017 CN 201721782146 U
(71) Applicant: Miasolé Equipment Integration (Fujian) Co., Ltd., 362005 Quanzhou Fujian (CN)
(72) Inventor: The designation of the inventor has not yet been filed
(74) Representative: Tiburzi, Andrea
(86) International application number: PCT/CN2018/091796
(87) International publication number: WO 2019/119754

(57) **Abstract**

The present disclosure provides a sunshade umbrella, which includes an umbrella rod, an umbrella body at an end of the umbrella rod, an umbrella handle at an opposite end of the umbrella rod, a solar cell component, a current output structure in the umbrella handle and in an electrical connection with the solar cell component, a first connection structure at the umbrella body and a second connection structure at the solar cell component. The solar cell component is detachably mounted to the umbrella body through detachable engagement between the first connection structure and the second connection structure.

## Description

### CROSS-REFERENCE TO RELATED APPLICATION

This application is based on and claims priority of Chinese Patent Application No. 201721782146.1, filed on December 19, 2017, which is incorporated herein by reference in its entirety.

### TECHNICAL FIELD

The present disclosure relates to the field of solar cell technology, and in particular to a sunshade umbrella.

### BACKGROUND

As people's requirements for quality of life increase, sunshade umbrellas play an increasingly important role in life. For example, the sunshade umbrellas may be required at outdoor cafes, fruit stalls, beach and personal use. However, the sunshade umbrellas usually only have a single function of shading the sun and windshield, and cannot meet people's increasingly diverse requirements.

### SUMMARY

The present disclosure provides a sunshade umbrella, which includes an umbrella rod, an umbrella body at an end of the umbrella rod, an umbrella handle at an opposite end of the umbrella rod, a solar cell component, a current output structure in the umbrella handle and in an electrical connection with the solar cell component, a first connection structure at the umbrella body and a second connection structure at the solar cell component. The solar cell component is detachably mounted to the umbrella body through detachable engagement between the first connection structure and the second connection structure.

In the above sunshade umbrella, optionally, each of the first connection structure and the second connection structure includes a connection negative terminal and a connection positive terminal. The connection positive terminal of the first connection structure is insertable in the connection negative terminal of the second connection structure; and the connection positive terminal of the second connection structure is insertable in the connection negative terminal of the first connection structure.

In the above sunshade umbrella, optionally, the connection negative terminal is a hole; and the connection positive terminal is a protruding structure.

In the above sunshade umbrella, optionally, the solar cell component includes a central connection portion, a solar cell unit, a third connection structure at the solar cell unit and a fourth connection structure at the central connection portion. The solar cell unit is detachably mounted to the central connection portion through detachable engagement between the third connection structure and the fourth connection structure. The second connection structure is at the central connection portion; the central connection portion is detachably mounted to the umbrella body through detachable engagement between the first connection structure and the second connection structure.

In the above sunshade umbrella, optionally, each of the third connection structure and the fourth connection structure includes a connection negative terminal and a connection positive terminal. The connection positive terminal of the third connection structure is insertable in the connection negative terminal of the fourth connection structure; and the connection positive terminal of the fourth connection structure is insertable in the connection negative terminal of the third connection structure.

In the above sunshade umbrella, optionally, the connection negative terminal of each of the third connection structure and the fourth connection structure is a hole; and the connection positive terminal of each of the third connection structure and the fourth connection structure is a protruding structure.

In the above sunshade umbrella, optionally, the solar cell unit includes a plurality of monolithic cells and a fifth connection structure at each monolithic cell; every two adjacent monolithic cells are detachably connected through detachable engagement between the fifth connection structures.

In the above sunshade umbrella, optionally, each fifth connection structure includes a connection negative terminal and a connection positive terminal; the connection negative terminal of each fifth connection structure is a hole; and the connection positive terminal of each fifth connection structure is a protruding structure.

In the above sunshade umbrella, optionally, the solar cell component includes a central connection portion, a substrate, a solar cell unit at the substrate, a fourth connection structure at the central connection portion, and a sixth connection structure at the substrate. The substrate is detachably mounted to the central connection portion through detachable engagement between the sixth connection structure and the fourth connection structure. The second connection structure is at the central connection portion; the central connection portion is detachably mounted to the umbrella body through detachable engagement between the first connection structure and the second connection structure.

In the above sunshade umbrella, optionally, each of the fourth connection structure and the sixth connection structure includes a connection negative terminal and a connection positive terminal. The connection positive terminal of the fourth connection structure is insertable in the connection negative terminal of the sixth connection structure; and the connection positive terminal of the sixth connection structure is insertable in the connection negative terminal of the fourth connection structure.

In the above sunshade umbrella, optionally, the connection negative terminal of each of the fourth connection structure and the sixth connection structure is a hole; and the connection positive terminal of each of the fourth connection structure and the sixth connection structure is a protruding structure.

In the above sunshade umbrella, optionally, the solar cell component further includes a seventh connection structure at the solar cell unit and an eighth connection structure at the substrate; the solar cell unit is detachably mounted to the substrate through detachable engagement between the seventh connection structure and the eighth connection structure.

In the above sunshade umbrella, optionally, each of the seventh connection structure and the eighth connection structure includes a connection negative terminal and a connection positive terminal. The connection positive terminal of the seventh connection structure is insertable in the connection negative terminal of the eighth connection structure; and the connection positive terminal of the eighth connection structure is insertable in the connection negative terminal of the seventh connection structure.

In the above sunshade umbrella, optionally, the connection negative terminal of each of the seventh connection structure and the eighth connection structure is a hole; and the connection positive terminal of each of the seventh connection structure and the eighth connection structure is a protruding structure.

In the above sunshade umbrella, optionally, the solar cell component includes a plurality of solar cell units; the solar cell units are disposed on the substrate around the central connection portion.

In the above sunshade umbrella, optionally, a clamping ring and a clamping post are provided at two opposite sides of each solar cell unit, respectively; in every two adjacent solar cell units, the clamping post of one of the two adjacent solar cell units is pivotally snapped into the clamping ring of the other one of the two adjacent solar cell units.

In the above sunshade umbrella, optionally, the sunshade umbrella further includes a battery. The battery is in the umbrella handle; and the battery is coupled to the solar cell component.

In the above sunshade umbrella, optionally, the sunshade umbrella further includes a voltage regulator circuit; wherein the voltage regulator circuit is coupled to the solar cell component.

In the above sunshade umbrella, optionally, the solar cell component is coupled to the battery, the current output structure and the voltage regulator circuit through the wire; the umbrella rod is a hollow structure, and the wire is within the hollow structure.

In the above sunshade umbrella, optionally, the current output structure is a socket in the umbrella handle.

### BRIEF DESCRIPTION OF THE DRAWINGS

Fig. 1 is a schematic view of a sunshade umbrella according to an embodiment of the present disclosure;
Fig. 2 is an exploded view of the sunshade umbrella according to an embodiment of the present disclosure;
Fig. 3 is a schematic view of a solar cell unit according to an embodiment of the present disclosure;
Fig. 4 is a schematic view of a connection structure according to an embodiment of the present disclosure;
Fig. 5 is a schematic view showing engagement between two connection structures according to an embodiment of the present disclosure;
Fig. 6 is a schematic view of a clamping ring according to an embodiment of the present disclosure; and
Fig. 7 is a schematic view of a clamping post according to an embodiment of the present disclosure.

### DETAILED DESCRIPTION

Reference will now be made in detail to exemplary embodiments, examples of which are illustrated in the accompanying drawings. The following description refers to the accompanying drawings in which the same numbers in different drawings represent the same or similar elements unless otherwise indicated. The following description of exemplary embodiments is merely used to illustrate the present disclosure and is not to be construed as limiting the present disclosure.

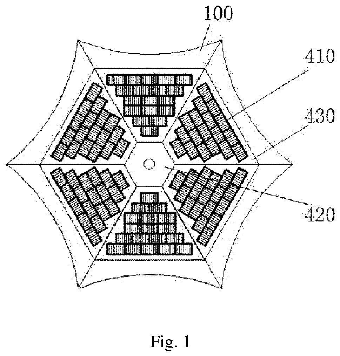

Referring to Fig. 1 to Fig. 5, a sunshade umbrella provided in some embodiments of the present disclosure includes an umbrella body 100, an umbrella rod 200, an umbrella handle 300, connection structures 500 and a solar cell component 400. Two ends of the umbrella rod 200 are connected with the umbrella body 100 and the umbrella handle 300, respectively. The solar cell component 400 is detachably mounted to the umbrella body 100 through the connection structures 500.

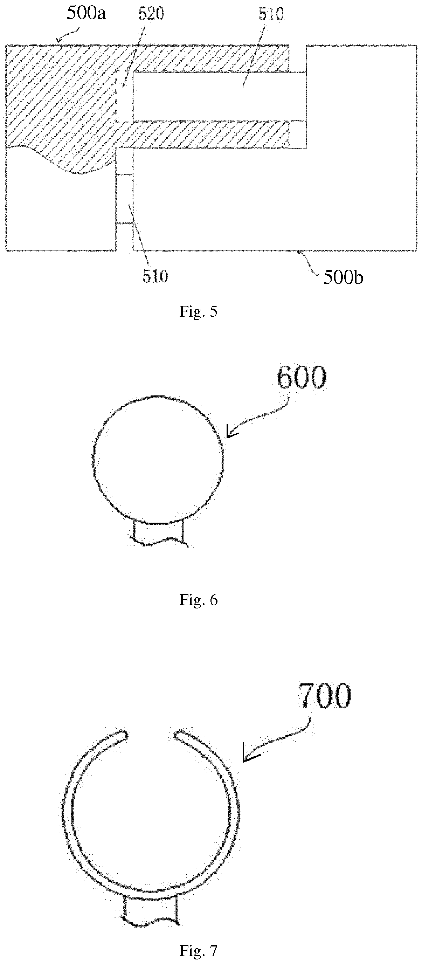

In one embodiment, the connection structure 500 includes a connection negative terminal and a connection positive terminal. The connection negative terminal is a hole 520. The connection positive terminal is a protruding structure 510 (as shown in Fig. 5) that is capable of being inserted into the hole of another connection structure. The umbrella handle 300 is provided with a current output structure 302. The current output structure is electrically coupled to the solar cell component 400. In one embodiment, the current output structure 302 may be a socket provided in the umbrella handle 300, and may be coupled to the connection structure 500 through a wire 301 extending in the umbrella handle 300 and the umbrella rod 200, and then is electrically coupled to the solar cell component 400 through the connection structure.

In sunny days, after the sunshade umbrella is unfolded, the solar cell component 400 may be mounted to the umbrella body 100 through the connection structures 500, thereby converting solar energy into electrical energy and then supplying power to an electrical device through the current output structure without an external power source. At night or in rainy days, or in weak light environment in which the solar cell component 400 cannot carry out effective photoelectric conversion, the solar cell component 400 can be removed away from the umbrella body 100 by disassembling the connection structures 500, thereby preventing service life of the solar cell component 400 from being shorten due to bad weather. In addition, if the solar cell component 400 is non-detachably fixed to the umbrella body 100, after the utilization of the sunshade umbrella, it is difficult to fold up the umbrella body 100 as the umbrella body 100 is supported by the solar cell component 400, and it is not convenient for use and management; while in the sunshade umbrella provided in some embodiments of the present disclosure, the solar cell component 400 can be removed away from the umbrella body 100 in an unused state, which is convenient for folding up the umbrella body 100 and maintenance of the solar cell component 400.

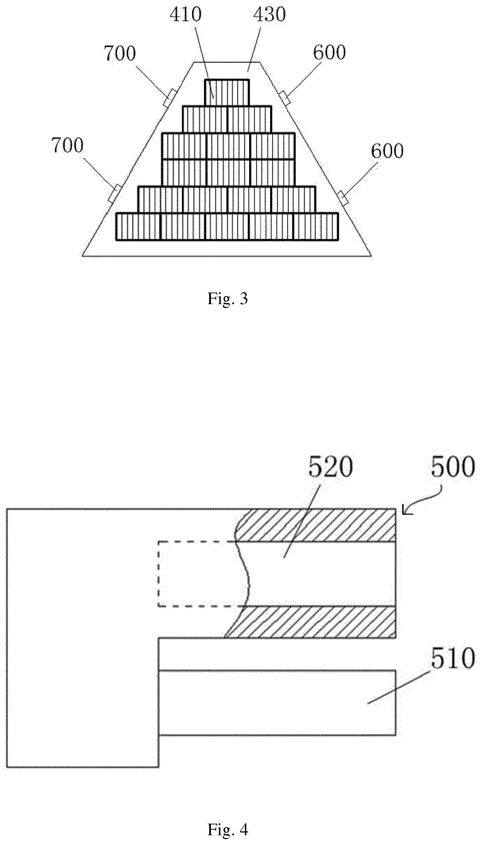

Specifically, referring to Fig. 4 and Fi. 5, one connection structure 500a (which is also referred as a first connection structure) may be fixed to the umbrella body 100. Another connection structure 500b (which is also referred as a second connection structure) capable of engaging with the connection structure 500a may be fixed to one side of the solar cell component 400, and the one side of the solar cell component 400 engages with the umbrella body 100. The first connection structure 500a and the second connection structure 500b may be inserted into each other, thereby enabling the umbrella body 100 to be electrically coupled to the solar cell component 400 through mutual insertion of the two connection structures 500.

Specifically, in order to facilitate mounting of the solar cell component 400 on the umbrella body 100, the solar cell component 400 includes a central connection portion 420 and a solar cell unit 410. The solar cell unit 410 is detachably mounted to the central connection portion 420 through detachable engagement between the connection structures 500 (i.e., detachable engagement between a third connection structure 500 disposed on the solar cell unit 410 and a fourth connection structure disposed on the central connection portion 420). The central connection portion 420 is connected with the umbrella body 100 through the connection structure 500 (i.e., the second connection structure).

One connection structure 500 such as the second connection structure may be disposed on one surface of the central connection portion 420 for engaging with the umbrella body 100, and may engage with one connection structure 500 such as the first connection structure on the umbrella body 100 by means of mutual insertion. One connection structure 500 such as the fourth connection structure may be disposed at a lateral side of the central connection portion 420 for engaging with one connection structure 500 such as the third connection structure on the solar cell unit 410.

Further, as shown in Fig. 3, the solar cell unit 410 may include a plurality of monolithic cells connected through connection structures 500. Each monolithic cell may be provided with one connection structure 500 (which may be referred as a fifth connection structure). Then, a certain quantity of the monolithic cells may be connected in series through the connection structures 500 (i.e., fifth connection structures) according to a size of the umbrella body 100. In this way, the solar cell unit 410 is suitable for the umbrella body 100 of different sizes.

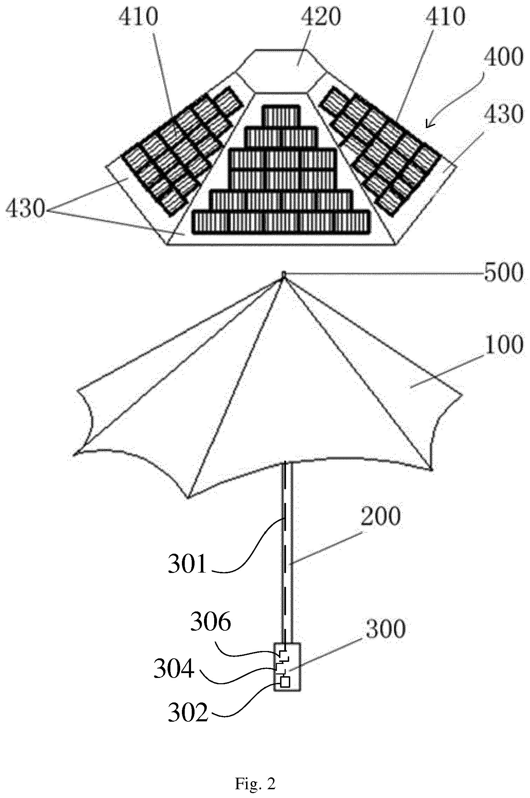

Further, as shown in Fig. 2 and Fig. 3, the solar cell component 400 further includes a substrate 430. The substrate 430 is detachably mounted to the central connection portion 420 through detachable engagement between the connection structures 500 (i.e., detachable engagement between a sixth connection structure disposed on the substrate 430 and the fourth connection structure disposed on the central connection portion 420). When the solar cell component 400 includes the substrate 430, the above third connection structure disposed on the solar cell unit 410 may be omitted, or the above third connection structure disposed on the solar cell unit 410 and the sixth connection structure disposed on the substrate 430 may be implemented as an identical connection structure. The solar cell unit 410 is detachably mounted to the substrate 430 through detachable engagement between the connection structures 500 (i.e., detachable engagement between a seventh connection structure disposed on the solar cell unit 410 and an eighth connection structure disposed on the substrate 430).

Each of the central connection portion 420 and the substrate 430 may be a hollow structure for accommodating circuits, thereby protecting the circuits.

Specifically, in order to improve photoelectric conversion efficiency of the solar cell unit 410 and ensure providing enough power, there may be two or more solar cell units 410. The quantity of the solar cell units 410 may be varied and may be set according to the size of the umbrella body 100 and power consumption of the electrical device, which are not specifically limited.

Further, referring to Fig. 3, Fig. 6 and Fig. 7, a clamping ring 700 and a clamping post 600 may be provided at two opposite sides of the solar cell unit 410, respectively. The clamping post 600 of one solar cell unit 410 may be snapped into the clamping ring 700 of another adjacent solar cell unit 410, thereby ensuring that a variety of the solar cell units 410 can be assembled together in proper shapes to fit the umbrella body 100. In addition, since the clamping post 600 may be snapped into the clamping ring 700 and an engagement surface between the clamping post 600 and the clamping ring 700 is a cylindrical surface, the solar cell units 410 may be adjusted in the snapping process. In other words, the rotatable engagement between the clamping post 600 and the clamping ring 700 can ensure engagement between the solar cell units 410 and the umbrella body 100.

In order to enable the sunshade umbrella of some embodiments of the present disclose to provide external power supply when the solar cell component 400 cannot carry out effective photoelectric conversion, the sunshade umbrella may further include a battery 304. The battery 304 may be disposed in the umbrella handle 300. The battery 304 is coupled to the solar cell component 400. The battery can store surplus electricity generated by the solar cell component 400. Thus, electricity demands of the electricity device in various weather conditions can be satisfied.

It should be noted that, in order to adjust the current generated by the solar cell component 400 through photoelectric conversion into a stable direct current so as to ensure normal operation of the electrical device, a voltage regulator circuit 306 may be disposed in the umbrella handle 300. The voltage regulator circuit 306 is coupled to the solar cell component 400.

It can be understood that the solar cell component 400 may be coupled to the battery 304, the current output structure 302 and the voltage regulator circuit 306 through the wire 301. In order to protect the wire, the umbrella rod 200 may be a hollow structure for accommodating the wire therein.

It should be noted that, the first connection structure, the second connection structure, the third connection structure, the fourth connection structure, the fifth connection structure, the sixth connection structure, the seventh connection structure and the eighth connection structure may have the same structure and connection mode, for example, they may employ the structure and connection mode shown in Fig. 4 and Fig. 5.

In the sunshade umbrella according to some embodiments of the present disclosure, the presence of the solar cell component 400 enables the sunshade umbrella to provide power supply. Meanwhile, the solar cell component can be removed away from the umbrella body in an unused state, which is convenient for folding up the umbrella body and maintenance of the solar cell component.

Based on the embodiments shown in the drawings, the structure, characteristics and effect of the present disclosure are explained in detail. The above are merely the optional embodiments of the present disclosure and shall not be used to limit the scope of the present disclosure. It should be noted that, a person skilled in the art may make improvements and modifications without departing from the principle of the present disclosure, and these improvements and modifications shall also fall within the scope of the present disclosure.

## Claims

1. A sunshade umbrella comprising:
an umbrella rod;
an umbrella body at an end of the umbrella rod;
an umbrella handle at an opposite end of the umbrella rod;
a solar cell component;
a current output structure in the umbrella handle and in an electrical connection with the solar cell component;
a first connection structure at the umbrella body; and
a second connection structure at the solar cell component;
wherein the solar cell component is detachably mounted to the umbrella body through detachable engagement between the first connection structure and the second connection structure.

2. The sunshade umbrella of claim 1, wherein each of the first connection structure and the second connection structure includes a connection negative terminal and a connection positive terminal; and
wherein the connection positive terminal of the first connection structure is insertable in the connection negative terminal of the second connection structure; and the connection positive terminal of the second connection structure is insertable in the connection negative terminal of the first connection structure.

3. The sunshade umbrella of claim 2, wherein the connection negative terminal is a hole; and the connection positive terminal is a protruding structure.

4. The sunshade umbrella of claim 2, wherein the solar cell component includes a central connection portion, a solar cell unit, a third connection structure at the solar cell unit and a fourth connection structure at the central connection portion;
wherein the solar cell unit is detachably mounted to the central connection portion through detachable engagement between the third connection structure and the fourth connection structure; and
wherein the second connection structure is at the central connection portion; the central connection portion is detachably mounted to the umbrella body through detachable engagement between the first connection structure and the second connection structure.

5. The sunshade umbrella of claim 4, wherein each of the third connection structure and the fourth connection structure includes a connection negative terminal and a connection positive terminal; and
wherein the connection positive terminal of the third connection structure is insertable in the connection negative terminal of the fourth connection structure; and the connection positive terminal of the fourth connection structure is insertable in the connection negative terminal of the third connection structure.

6. The sunshade umbrella of claim 5, wherein the connection negative terminal of each of the third connection structure and the fourth connection structure is a hole; and the connection positive terminal of each of the third connection structure and the fourth connection structure is a protruding structure.

7. The sunshade umbrella of claim 4, wherein the solar cell unit includes a plurality of monolithic cells and a fifth connection structure at each monolithic cell; every two adjacent monolithic cells are detachably connected through detachable engagement between the fifth connection structures.

8. The sunshade umbrella of claim 7, wherein each fifth connection structure includes a connection negative terminal and a connection positive terminal; the connection negative terminal of each fifth connection structure is a hole; and the connection positive terminal of each fifth connection structure is a protruding structure.

9. The sunshade umbrella of claim 2, wherein the solar cell component includes a central connection portion, a substrate, a solar cell unit at the substrate, a fourth connection structure at the central connection portion, and a sixth connection structure at the substrate;
wherein the substrate is detachably mounted to the central connection portion through detachable engagement between the sixth connection structure and the fourth connection structure; and
wherein the second connection structure is at the central connection portion; the central connection portion is detachably mounted to the umbrella body through detachable engagement between the first connection structure and the second connection structure.

10. The sunshade umbrella of claim 9, wherein each of the fourth connection structure and the sixth connection structure includes a connection negative terminal and a connection positive terminal; and
wherein the connection positive terminal of the fourth connection structure is insertable in the connection negative terminal of the sixth connection structure; and the connection positive terminal of the sixth connection structure is insertable in the connection negative terminal of the fourth connection structure.

11. The sunshade umbrella of claim 10, wherein the connection negative terminal of each of the fourth connection structure and the sixth connection structure is a hole; and the connection positive terminal of each of the fourth connection structure and the sixth connection structure is a protruding structure.

12. The sunshade umbrella of claim 9, wherein the solar cell component further includes a seventh connection structure at the solar cell unit and an eighth connection structure at the substrate; the solar cell unit is detachably mounted to the substrate through detachable engagement between the seventh connection structure and the eighth connection structure.

13. The sunshade umbrella of claim 12, wherein each of the seventh connection structure and the eighth connection structure includes a connection negative terminal and a connection positive terminal; and
wherein the connection positive terminal of the seventh connection structure is insertable in the connection negative terminal of the eighth connection structure; and the connection positive terminal of the eighth connection structure is insertable in the connection negative terminal of the seventh connection structure.

14. The sunshade umbrella of claim 13, wherein the connection negative terminal of each of the seventh connection structure and the eighth connection structure is a hole; and the connection positive terminal of each of the seventh connection structure and the eighth connection structure is a protruding structure.

15. The sunshade umbrella of claim 9, wherein the solar cell component includes a plurality of solar cell units; and the solar cell units are disposed on the substrate around the central connection portion.

16. The sunshade umbrella of claim 15, wherein a clamping ring and a clamping post are provided at two opposite sides of each solar cell unit, respectively; in every two adjacent solar cell units, the clamping post of one of the two adjacent solar cell units is pivotally snapped into the clamping ring of the other one of the two adjacent solar cell units.

17. The sunshade umbrella of claim 1, further comprising a battery; wherein the battery is in the umbrella handle; and the battery is coupled to the solar cell component.

18. The sunshade umbrella of claim 17, further comprising a voltage regulator circuit; wherein the voltage regulator circuit is coupled to the solar cell component.

19. The sunshade umbrella of claim 17, wherein the solar cell component is coupled to the battery, the current output structure and the voltage regulator circuit through a wire; the umbrella rod is a hollow structure, and the wire is within the hollow structure.

20. The sunshade umbrella of claim 1, wherein the current output structure is a socket in the umbrella handle.
